(19) Europäisches Patentamt
European Patent Office
Office européen des brevets

(11) Veröffentlichungsnummer: **0 503 402 A1**

(12) # EUROPÄISCHE PATENTANMELDUNG

(21) Anmeldenummer: **92103492.2**

(51) Int. Cl.$^5$: **G03F 3/10**

(22) Anmeldetag: **29.02.92**

(30) Priorität: **08.03.91 DE 4107390**

(43) Veröffentlichungstag der Anmeldung:
**16.09.92 Patentblatt 92/38**

(84) Benannte Vertragsstaaten:
**DE FR GB IT**

(71) Anmelder: **HOECHST AKTIENGESELLSCHAFT**
**Postfach 80 03 20**
**W-6230 Frankfurt am Main 80(DE)**

(72) Erfinder: **Benzing, Martin, Dr.**
**Burgunderstrasse 26**
**W-6501 Mommenheim(DE)**
Erfinder: **Elsässer, Andreas, Dr.**
**Hertastrasse 1b**
**W-6270 Idstein(DE)**
Erfinder: **Mertes, Jürgen, Dr.**
**Winkeler Strasse 2b**
**W-6507 Ingelheim(DE)**
Erfinder: **Mohr, Dieter, Dr.**
**Eaubonner Strasse 8**
**W-6501 Budenheim(DE)**

(54) **Gefärbtes, positiv arbeitendes, lichtempfindliches Aufzeichnungsmaterial und Verfahren zur Herstellung sowohl positiver als auch negativer Farbprüfbilder unter Verwendung dieses Materials.**

(57) Die Erfindung betrifft ein gefärbtes, positiv arbeitendes, lichtempfindliches Aufzeichnungsmaterial zur Herstellung eines Farbprüfbildes, bestehend aus einem temporären Schichtträger, auf dem sich eine Trennschicht auf Basis von Polyvinylalkohol befindet, einer Farbstoff oder Pigment, novolakfreies, phenolisches Polymerharz und/oder ein Umsetzungsprodukt des phenolischen Polymerharzes mit einem Monoisocyanat als Bindemittel und ein Veresterungsprodukt aus einer Verbindung mit einer oder mehreren phenolische Hydroxylgruppen und o-Chinondiazidsulfonsäurechlorid als Chinondazidverbindung enthaltenden lichtempfindlichen Schicht und aus einer thermisch aktivierbaren, Styrol-Butadien-Copolymerisat und alkali-löslichen Polyester enthaltenden Klebeschicht, das in der lichtempfindlichen Schicht ein Veresterungsprodukt mit einem o-Chinondiazid-4-sulfonsäurechlorid als Chinondiazidverbindung, eine weichmachende Verbindung und/oder eine basische Stickstoff- oder Harnstoffverbindung enthält.
Die Erfindung betrifft auch ein Verfahren zur Herstellung positiver und/oder negativer Farbprüfbilder in naturgetreuer Wiedergabe bei leicht handhabbarem Verfahren mit breitem Verarbeitungsspielraum.

EP 0 503 402 A1

Die vorliegende Erfindung betrifft ein gefärbtes, positiv arbeitendes, lichtempfindliches Aufzeichnungsmaterial zur Herstellung eines Farbprüfbildes auf einem permanenten Schichtträger, ausgehend von einem Material bestehend aus einem temporären Schichtträger, einer Trennschicht, einer Farbstoff oder Pigment, Bindemittel und o-Chinondiazidverbindung enthaltenden lichtempfindlichen Schicht und einer thermisch aktivierbaren Klebeschicht. Sie betrifft auch ein Verfahren zur Herstellung sowohl eines positiven als auch eines negativen Farbprüfbildes unter Verwendung dieses Materials.

Im Mehrfarbendruck wird im allgemeinen eine Farbprüfung vorgenommen um die Korrektur der für die Belichtung von Druckplatten verwendeten Farbauszüge zu ermöglichen. Das Farbprüfbild muß ein getreues Abbild des gewünschten Raster- oder Strichbildes sein und soll den Tonwert der Farben naturgetreu, d.h. weder erhöht noch herabgesetzt, wiedergeben. Die visuelle Farbprüfung soll Fehler in der Vorlage anzeigen, die beste Farbwiedergabe, die beim Drucken in der Maschine zu erwarten ist, ermöglichen, die genaue Gradation aller Farbtöne wiedergeben und aufzeigen, ob die Grautöne neutral sind. Sie soll ferner die eventuelle Notwendigkeit zur Abschwächung einer der Farben angeben und/oder Hinweise zur Änderung der Filmvorlage vor der Herstellung der Druckplatten liefern.

Die Farbprüfung für den Mehrfarbendruck wird bisher mit Hilfe von Farbandrucken vorgenommen, wobei man alle auch beim tatsächlichen Mehrfarbendruck notwendigen Schritte durchführen muß. Ein solches Farbprüfverfahren ist kostspielig und zeitaufwendig, und man hat deshalb andere Farbprüfverfahren entwickelt, die dem Andruck in der Qualität gleichkommen sollen. Drei Farbprüfverfahren mittels lichtempfindlicher Farbprüffolien sind bekannt, das Surprint-Verfahren (Übereinanderlaminieren), das Surlay-Verfahren (Übereinanderkopieren), und das Overlay-Verfahren (Übereinanderlegen).

Die DE-A 27 12 864, entsprechend GB-A 1 550 524, beschreibt eine positiv arbeitende Farbfolie, die aus einem transparenten Schichtträger, einer lichtempfindlichen, Diazoniumsalz enthaltenden Schicht und einer dünnen Farbschicht mit einem darin dispergierten Pigment besteht. Kennzeichnend ist für diese Farbprüffolie eine spezielle Schichtenanordnung, wobei in jedem Fall die Schicht mit der lichtempfindlichen Diazoniumverbindung, bezogen auf das Stadium der Belichtung, über der Farbschicht liegen soll.

Die EP-A 0 035 028, entsprechend US-A 4 260 673, bezieht sich auf einen vorsensibilisierten Farbprüfbogen mit folgendem Schichtaufbau: ein Trägerblatt ist mit einer Antihaftfläche bedeckt, auf der eine Farbschicht aufgetragen ist, danach folgt eine Novolak enthaltende Bindemittelschicht, die ein Reaktionsprodukt eines Harzes und eines Diazooxids enthält und frei von Pigmenten ist. Auf diese Bindemittelschicht folgen dann noch eine Sperrschicht und eine Antihaftschicht.

In der EP-A 0 165 031, entsprechend US-A 4 656 114, wird ein Farbprüfblatt offenbart, bei dem zwischen der Farbschicht und der Adhäsivschicht noch eine zusätzliche wasserunlösliche, transparente Trennschicht liegt, durch die eine Diffusion von Stoffen in Nachbarschichten verhindert werden soll.

Vorrangiges Ziel der bekannten Farbprüfsysteme ist es, ein Mehrfarbenbild zu erzeugen, das dem angestrebten Vierfarbendruck in seinem Aussehen möglichst nahe kommt. Die Herstellung von Farbprüfbildern kann dabei auf verschiedenen Wegen realisisiert werden.

Die US-A 3 671 236 beschreibt ein Verfahren, bei dem nacheinander Teilfarbenbilder in den verschiedenen Grundfarben gemäß den entsprechenden Farbauszügen auf ein Empfangsblatt zu einem Vierfarb-Gesamtbild zusammengesetzt werden.

In der US-A 3 721 557, entsprechend DE-B 19 12 864, wird ein Verfahren zur Übertragung von Farbbildern beschrieben, bei dem zwischen der lichtempfindlichen Schicht und dem Schichtträger eine Abziehschicht aufgebracht ist. Wenn die lichtempfindliche Schicht entwickelt wird, werden die löslichen Bestandteile der Schicht selektiv entfernt und es entsteht ein sichtbares Bild. Der Schichtträger mit dem Bild wird gegen ein geeignetes mit Klebstoff beschichtetes Empfangsmaterial gepreßt und dann die Bildübertragung durch Abziehen des Schichtträgers vorgenommen. Für jede weitere Bildübertragung wird eine neue Klebstoffschicht auf das Empfangsmaterial aufgetragen.

Aus der DE-A 22 36 941, entsprechend US-A 4 093 464, ist ein Farbprüfverfahren bekannt, bei dem positiv arbeitende, lichtempfindliche Schichten, die in den gewünschten Grundfarben eingefärbt sind und sich jeweils auf einer temporären Trägerfolie befinden, auf dieser Folie belichtet und entwickelt werden. Die erhaltenen Teilfarbenbilder werden auf ein Bildempfangsmaterial, z.B. ein Bedruckpapier, durch Laminieren im Register übertragen. Dieses Verfahren erfordert sehr präzises Arbeiten und ist deshalb sehr aufwendig. Auch läßt sich das Laminieren im Register von entwickelten Bildern nur mit Schichten durchführen, die noch ausreichend thermoplastisch sind, also in der Regel nur mit positiv arbeitenden Schichten, die zudem noch bestimmte plastifizierende Zusätze enthalten.

Gemäß EP-A 0 035 028 wird zur Herstellung eines Mehrfarben-Prüfbildes das mehrschichtige Material auf ein Bildempfangsmaterial, das ein wasserfest ausgerüstetes Papier darstellt, laminiert, dort belichtet und zum Teilfarbenbild entwickelt. Die übrigen Teilfarbenbilder werden über dem ersten in gleicher Weise erzeugt. Nach diesem Verfahren lassen sich passergenaue Mehrfarbenbilder leichter erhalten, da nur im

Register belichtet zu werden braucht. Das Verfahren hat den Nachteil, daß es für jede Grundfarbe mehrere übereinanderliegende Schichten erfordert und daß die Bildelemente noch jeweils zwei Schichten mit unzersetzter gefärbter Diazoverbindung enthalten.

In der nicht vorveröffentlichten deutschen Patentanmeldung, Aktenzeichen P 40 06 856.0, wird ein positiv arbeitendes, gefärbtes lichtempfindliches Aufzeichnungsmaterial vorgeschlagen zur Herstellung eines Farbprüfbildes aus einem temporären Schichtträger, einer Trennschicht, einer Farbstoff oder Pigment, Bindemittel und Chinondiazidverbindung enthaltenden lichtempfindlichen Schicht und einer thermisch aktivierbaren Klebeschicht, wobei die Trennschicht auf der Basis von Polyvinylalkohol aufgebaut ist und das Bindemittel ein novolakfreies, phenolisches Polymerharz und/oder ein Umsetzungsprodukt des phenolischen Polymerharzes mit einem Monoisocyanat darstellt. Die thermisch aktivierbare Klebeschicht enthält oder besteht aus einem Styrol-Butadien-Copolymerisat und einem alkalilöslichen Polyester.

Die bisher beschriebenen Verfahren arbeiten entweder positiv oder negativ. Ein System bei welchem sowohl positiv als auch negativ, ja sogar auf demselben Empfangsmaterial positiv und negativ gearbeitet werden kann, ist auf dem Gebiet der Farbprüffolien bei einem Peel-Apart-System bekannt. Die US-A 4 923 780 beschreibt ein Verfahren, bei dem eine Löslichkeitsdifferenzierung vor dem Entwickeln durch Abziehen der Trägerfolie mit Hilfe von aktinischem Licht unterschiedlicher Wellenlänge in zwei aueinanderfolgenden Belichtungen erreicht wird.

Bei der Herstellung von Offsetdruckplatten jedoch sind solche Verfahren auch bei Naßentwicklung und dem Einsatz nur einer Lichtquelle geläufig. So beschreibt die DE-A 33 25 023, entsprechend US-A 4 576 901, eine positiv arbeitende Offsetdruckplatte, mit einer in 4-Position substituierten o-Chinondiazidverbindung als lichtempfindliche Substanz in der lichtempfindlichen Schicht. Mit Hilfe dieser Platte kann man durch die Verfahrensschritte - Belichten, Tempern, vollflächiges Belichten und Entwickeln - auch negative Filmvorlagen verarbeiten.

Die DE-A 37 11 263 beschreibt ein Aufzeichnungsmaterial mit einem s-Triazin-Zusatz in der Kopierschicht, das für das Umkehrverfahren geeignet ist. Der Zusatz erweitert den Temperaturbereich, in welchem Bildumkehr stattfinden kann.

Eine einfache Übertragung dieses Prinzips von der Herstellung von Offsetdruckplatten auf ein Farbprüfsystem ist jedoch nicht möglich, da die thermische Belastbarkeit des bisher bekannten Farbprüfmaterials stark eingeschränkt ist. Bei einer Verarbeitung, wie man sie zur Umkehr bei Druckplatten auf Aluminiumträger anwendet, gerät zum einen die Maßstabilität des permanenten Schichtträgers außer Kontrolle und zum anderen bildet sich ein Netzwerk von unerwünschten Rissen in dem aus verschiedenen Schichten aufgebauten Farbprüfbild.

Aufgabe der vorliegenden Erfindung war es deshalb, ein lichtempfindliches Aufzeichnungsmaterial für den Mehrfarbenandruck anzugeben, das eine farbortgetreue Wiedergabe ermöglicht, einen ausreichenden Entwicklerkontrast zwischen belichteten und unbelichteten Bereichen ergibt und sowohl mit positiven Filmvorlagen als auch mit negativen Filmvorlagen einsetzbar ist, auch dann, wenn positive und negative Filmvorlagen gleichzeitig in einem Sammelfarbprüfbild verarbeitet werden.

Die Aufgabe geht aus von einem gefärbten, positiv arbeitenden, lichtempfindlichen Aufzeichnungsmaterial zur Herstellung eines Farbprüfbildes, bestehend aus einem temporären Schichtträger, auf dem sich eine Trennschicht aus einem Polymeren oder Copolymeren von Vinylalkohol, einem Vinylether oder Vinylacetat, eine lichtempfindliche Schicht, die einen Farbstoff oder ein Pigment, ein Bindemittel, das ein Novolak, ein novolakfreies Phenolharz und/oder ein Umsetzungsprodukt des Novolaks oder des Phenolharzes mit einem Monoisocyanat ist, und einen Ester aus einer Verbindung mit einer oder mehreren phenolischen Hydroxylgruppen und einer o-Chinondiazidsulfonsäure enthält, und eine thermisch aktivierbare, ein alkaliunlösliches Polymerisat und einen alkalilöslichen Polyester enthaltende Klebeschicht befindet.

Die Aufgabe wird dadurch gelöst, daß das Aufzeichnungsmaterial in der lichtempfindlichen Schicht einen Ester einer o-Chinondiazid-4-sulfonsäure sowie eine weichmachende Verbindung und/oder eine basische Stickstoff- oder Harnstoffverbindung enthält.

Der temporäre Schichtträger muß zumindest eine trennfähige Oberfläche aufweisen, d.h. er muß fähig sein, die lichtempfindliche Schicht so zu halten, daß sie wieder von ihm getrennt werden kann. Zu diesem Zweck kann entweder die Schichtträgeroberfläche von ihrer Natur her trennfähig sein, sie kann durch eine geeignete Behandlung trennfähig gemacht werden, oder sie kann mit einer Trennschicht versehen werden.

Als temporären Schichtträger verwendet man beispielsweise eine maßbeständige und chemisch stabile Polyesterfolie, die sich in Größe, Form und chemischen Eigenschaften nicht durch Erwärmen, Beschichten oder die anderen notwendigen Behandlungen wesentlich verändert. Vorzugsweise werden Folien aus Polyethylenterephthalat mit Dicken im Bereich von etwa 10 bis 250 µm, insbesondere 20 bis 100 µm verwendet.

Als Trennschicht dient erfindungsgemäß eine Schicht auf Basis von Polyvinylalkohol. Zu den geeigneten Polymeren gehören z.B. Polyvinylalkohol und dessen Partialester, Polyvinylether und -acetate, Copolymerisate aus Vinylalkohol und Olefinen, die allein oder im Gemisch eingesetzt werden können. Vorzugsweise dient als Polymer für die Trennschicht ein teilverseiftes Polyvinylacetat oder ein Gemisch teilverseifter Polyvinylacetate mit unterschiedlichen Molekulargewichten mit einem Hydrolysegrad von 80 bis 90 Molprozent.

Die Trennschicht besitzt ein Trockenschichtgewicht im Bereich von etwa 0,5 bis 2 $g/m^2$.

Das novolakfreie, phenolische Polymerharz ist vorzugsweise ein Polymerisat mit phenolischen Gruppen in der Seitenkette entsprechend der allgemeinen Formel

$$-(CH_2-\underset{\substack{|\\A\\|\\B-(OH)_o}}{C}R_1)_m-(CHR_2-CR_3R_4)_n- \qquad I$$

worin

R1 Wasserstoff oder eine Methylgruppe,

R2 Wasserstoff oder eine Carboxylgruppe,

R3 Wasserstoff, $(C_1-C_{12})$-Alkyl oder ein Halogenatom,

R4 Alkyl, Alkoxy, Alkoxycarbonyl mit jeweils 1 bis 4 C-Atomen, Acyloxy, Aryl, Formyl, Cyano, Carboxyl oder Hydroxyl und im Falle, daß $R_2$ eine Carboxylgruppe ist, mit dieser zu einem Säureanhydrid verbunden sein kann,

A eine Einfachbindung oder die Gruppe

$$-\overset{\substack{O\\\|}}{C}-O-,$$

B ein gegebenenfalls substituiertes ein- oder zweikerniges carbocyclisches aromatisches Ringsystem,

m 100 bis 60 Molprozent,

n 0 bis 40 Molprozent und

o 1 oder 2

bedeuten.

Besonders geeignete Polymerharze als Bindemittel sind Homo- oder Copolymerisate aus Brenzkatechinmonomethacrylat, Resorcinmonomethacrylat, Hydrochinonmonomethacrylat und 4-Hydroxystyrol, die allein oder im Gemisch vorhanden sind.

Das Molekulargewicht des Polymerisats kann in weiten Grenzen variiert werden. Die Polymerisate mit M = 20.000 - 50.000 werden dabei bevorzugt.

Die Hydroxylzahl liegt allgemein im Bereich von 100 bis 450, vorzugsweise zwischen 200 und 350. Der Mengenanteil an phenolischen Hydroxylgruppen enthaltenden Einheiten im Polymerisat richtet sich nach der praktischen Lichtempfindlichkeit der verschieden eingefärbten lichtempfindlichen Schichten. Der Mengenanteil wird weiter bestimmt durch die rasche Entwicklung mit wäßrig-alkalischen Lösungen und durch eine möglichst große Entwicklerresistenz der unbelichteten Bereiche. Die gewünschte Hydrophilie wird durch Umsetzung der OH-Gruppen mit z.B. Monoisocyanaten eingestellt. Hierzu gehören $(C_1-C_{10})$-Alkylisocyanat oder Arylisocyanat, wie Phenyl-, Alkylphenyl- oder Arylphenylisocyanat. Geeignete Isocyanate sind vorzugsweise Butylisocyanat, Cyclohexylisocyanat, n-Propylisocyanat. Insbesondere ist das Monoisocyanat des Umsetzungsproduktes mit dem Novolak oder dem phenolischen Polymerharz Phenylisocyanat.

Die Menge an Monoisocyanat liegt im Bereich von 0 bis 30 Gewichtsprozent, bezogen auf das anwesende Polymere.

Das Bindemittel ist in der gefärbten, lichtempfindlichen Schicht in einem Anteil von 20 bis 75, vorzugsweise 30 bis 70 Gewichtsprozent, bezogen auf die nichtflüchtigen Anteile der Schicht, vorhanden.

Die bei vielen Positiv-Kopiermaterialien auf Basis von Naphthochinondiaziden bewährten Novolak-Kondensationsharze haben sich als Bindemittel auch bei dem erfindungsgemäßen Material als vorteilhaft erwiesen. Die Novolake können auch in bekannter Weise, wie oben angegeben, durch Umsetzung eines

Teils ihrer Hydroxylgruppen, z.Bsp. mit Chloressigsäure, Epoxiden, Isocyanaten oder Carbonsäureanhydriden, modifiziert sein.

Zur Herstellung der erfindungsmäßen Gemische für die lichtempfindliche Schicht werden die beschriebenen Bindemittel mit einer farbgebenden Komponente und einer lichtempfindlichen Verbindung kombiniert. Letztere ist ein o-Chinondiazid, nämlich ein Kondensationsprodukt aus einer Verbindung mit einer oder mehreren phenolischen Hydroxylgruppen und einer o-Chinondiazidverbindung, vorzugsweise 1,2-Naphthochinon-(2)-diazid-4-sulfonsäurechlorid. Zu den Verbindungen mit einer oder mehreren phenolischen Hydroxylgruppen gehören z.B. 2,3,4- oder 2,4,6-Trihydroxybenzophenon, Bisphenol-A oder 4-tert.Butylphenol. Als o-Chinondiazide werden insbesondere Veresterungsprodukte des 1,2-Naphthochinon-(2)-diazid-4-sulfonsäurechlorids mit 2,3,4-Trihydroxybenzophenon verwendet, die nach dem Belichten keine Farbverschiebung der Farbprüffolie verursachen. Dabei sind die Mono-, Bis- und Trisester einsetzbar. Besonders bevorzugt wird der Trisester eingesetzt. Die Menge an o-Chinondiazidverbindung beträgt im allgemeinen 7 bis 50, vorzugsweise 12 bis 35 Gewichtsprozent, bezogen auf die nichtflüchtigen Bestandteile des lichtempfindlichen Gemisches.

Als Zusatz zur lichtempfindlichen Schicht ist erfindungsgemäß eine weichmachende Verbindung notwendig mit dem Zweck, daß bei dem zur Bildumkehr benötigten Temperschritt während der Negativverarbeitung keine Rißbildung in der Oberfläche des Farbprüfbildes eintritt und die zur Bildumkehr benötigte Temperatur in einem Bereich liegt, in dem der eingesetzte permanente Schichtträger nicht verändert oder beschädigt wird. Als Zusatz kommen in Frage Polyester, alkalilösliche Polyester, Halogenparaffine oder auch basische Stickstoffverbindungen, wie sekundäre oder tertiäre Amine oder Melaminderivate; Harnstoffverbindungen oder Gemische aus verschiedenen dieser Komponenten. Vorteilhaft hat sich als basische Stickstoffverbindung ein s-Triazin, insbesondere nach Formel A erwiesen,

Formel A

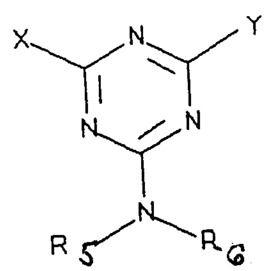

in welcher

| | |
|---|---|
| $R_5$, $R_6$ | H, Alkyl, $-CH_2$-O-Alkyl, |
| X, Y | $OR_7$, $N(R_8)_2$, Alkyl, Aryl und |
| $R_7$, $R_8$ | H oder Alkyl |

bedeuten.

Ganz besonders bewährt haben sich Verbindungen wie 2,4-Diethoxy-6-diethylamino-s-triazin oder 2,4,6-Tris-[N,N-bis(methoxymethyl)-amino]-1,3,5-triazin.

Die Menge beträgt dabei 0.1 bis 25, vorzugsweise 6 bis 14 Gewichtsprozent, bezogen auf die nichtflüchtigen Bestandteile des lichtempfindlichen Gemisches.

Zu den erfindungsgemäß eingesetzten Farbmitteln zählen verschiedene Farbstoff- und Pigmentklassen in den Grundfarben Cyan, Magenta, Gelb und Schwarz. Zur Erzielung bestimmter Farbtöne können auch Mischungen der verschiedenen Farbstoffe oder Pigmente verwendet werden. In der am meisten bevorzugten Ausführung werden Pigmente mit einer durchschnittlichen Teilchengröße von höchstens 1 µm eingesetzt.

Die einzelnen Komponenten werden in verträglichen Lösemitteln, wie z.B. Propylenglykolmonomethylether, Ethylenglykolmonomethylether und γ-Butyrolacton, gelöst und auf die Oberfläche des temporären Schichtträgers aufgetragen und getrocknet.

Die lichtempfindliche Schicht hat ein Schichtgewicht von 0.5 bis 5.0 g/m$^2$. Insbesondere liegt das Schichtgewicht zwischen 0.8 und 2.0 g/m$^2$.

Die thermisch aktivierbare Klebeschicht besteht vorzugsweise aus einem alkali-unlöslichen organischen Polymerisat und einem alkali-löslichen Polyesterharz. Ihr Erweichungsbereich soll unter 160 °C, vorzugsweise unter 100 °C liegen. Zudem soll die Klebeschicht bei Raumtemperatur nicht klebrig sein. Als geeignete Substanzen gehören hierzu z.B. Polyvinylacetat, Polyacrylsäureester, Acrylsäureester-Copolymere, Polymethacrylsäureester, Methacrylsäureester-Copolymere, Polyvinylchlorid, Vinylchlorid-Copolymere, Polystyrol, Styrol-Copolymere, Polyesterharze und Ethylen-Copolymere, z.B. Ethylen/Vinylacetat Copolymere, Ethylen/Acrylsäure-Copolymere.

Die Klebeschicht enthält 60 bis 99, vorzugsweise 70 bis 95 Gewichtsprozent an Styrol-Butadien Copolymerisat und 1 bis 40, vorzugsweise 5 bis 30 Gewichtsprozent alkali-löslichen Polyester.
Gut bewährt haben sich für die Klebeschicht auch Vinylacetatpolymerisate und/oder -copolymerisate oder Acrylatpolymerisate und/oder -copolymerisate, die je nach eingesetzter Verbindung, mit oder ohne Weichmacher vorhanden sind.

Die Klebeschicht besitzt ein Trockenschichtgewicht von etwa 2 bis 20, bevorzugt 3 bis 10 g/m$^2$.

Die Klebeschicht wird üblicherweise aus einem organischen Lösemittel auf die lichtempfindliche Schicht aufgebracht. Dabei wird ein Vermischen der beiden Schichten dadurch vermieden, daß man ein Lösungsmittel verwendet, das die lichtempfindliche untere Schicht nicht angreift.

Die bildmäßig belichteten Schichten können in bekannter Weise mit wäßrig alkalischen Lösungen entwickelt werden. Die wäßrigen Entwicklerlösungen können z.B. Alkaliphosphate, -silikate oder -hydroxide und ferner Netzmittel sowie geringe Mengen an organischem Lösemittel enthalten.

Die Erfindung betrifft auch ein Verfahren zur Herstellung sowohl eines positiven als auch eines negativen Farbprüfbildes, auch gleichzeitig positiv und negativ nebeneinander auf demselben Empfangsmaterial, unter Verwendung, des erfindungsgemäßen gefärbten lichtempfindlichen Aufzeichnungsmaterials.

Die Herstellung eines positiven Farbprüfbildes erfolgt nach bekannten Verfahren. Der Schichtverbund wird über die Klebeschicht auf einen permanenten Schichtträger unter Druck und Erwärmen auf etwa 110 bis 140 °C laminiert, die lichtempfindliche Schicht nach dem Entfernen des temporären Schichtträgers bildmäßig belichtet und die belichtete Schicht durch Auswaschen der belichteten Bereiche entwickelt. Zur Erstellung eines kompletten Farbprüfbildes wird ein weiteres lichtempfindliches Aufzeichnungsmaterial in einer anderen Grundfarbe über das zuvor hergestellte Bild auf denselben permanenten Schichtträger laminiert. Um die gesamte Farbwiedergabe zu erhalten, werden normalerweise vier Schichten in den Farben Cyan, Magenta, Gelb und Schwarz verwendet.

Dementsprechend wird bei dem erfindungsgemäßen Verfahren das Aufzeichnungsmaterial in der ersten Grundfarbe klebeschichtseitig auf einen permanenten Schichtträger mit Hilfe von Druck und Wärme auflaminiert, der temporäre Schichtträger abgezogen, das Aufzeichnungsmaterial unter dem positiven Farbauszug der entsprechenden Grundfarbe belichtet, die belichtete Schicht durch Auswaschen der belichteten Bereiche entwickelt und über dem erhaltenen Teilbild in entsprechender Weise Teilbilder der weiteren Grundfarben und von Schwarz erzeugt.

Ein negatives Farbprüfbild erhält man wie folgt:
Der Schichtverbund wird über die Klebeschicht auf einen permanenten Schichtträger unter Druck und Erwärmen laminiert und die lichtempfindliche Schicht nach dem Entfernen des temporären Schichtträgers und anschließendem feuchten Abwischen der Trennschicht bildmäßig belichtet. Im Falle des Abwischens wird vorzugsweise mit Wasser abgewaschen. Danach wird das belichtete Prüfbild etwa 0,5 bis 10, vorzugsweise 2 bis 6 Min, bei Temperaturen im Bereich von 70 bis 150 °C, vorzugsweise 80 bis 110 °C getempert, wodurch die belichteten Bereiche für den späteren Entwicklungsprozeß unlöslich werden. Variationen von Zeit oder Temperatur beeinflussen in entscheidendem Maße die Bildwiedergabe des negativen Farbprüfbildes. Anschließend wird ganzflächig ausbelichtet und die bildtragende Schicht durch Auswaschen der nachträglich belichteten Bereiche entwickelt. Die so ausgewaschenen Bildanteile sind identisch mit den bei der bildmäßigen Belichtung unbelichteten Stellen. Zur Erstellung eines kompletten Farbprüfbildes wird der Vorgang nacheinander mit den anderen Grundfarben wiederholt.

Bei diesem Verfahren wird erfindungsgemäß das Aufzeichnungsmaterial in der ersten Grundfarbe klebeschichtseitig auf einen permanenten Schichtträger mit Hilfe von Druck und Wärme auflaminiert, der temporäre Schichtträger abgezogen, die Trennschicht gegebenenfalls feucht abgewischt, das Aufzeichnungsmaterial unter einem negativen Farbauszug der entsprechenden Grundfarbe belichtet, das belichtete Prüfbild 0,5 bis 10 Min bei 70 bis 150 °C getempert, danach ganzflächig ausbelichtet und die so nachbelichtete Schicht durch Auswaschen der belichteten Bereiche entwickelt und über dem erhaltenen Teilbild in entsprechender Weise Teilbilder der weiteren Grundfarben und von Schwarz erzeugt.

Will man nebeneinander auf demselben permanenten Schichtträger sowohl ein positives als auch ein negatives Prüfbild erstellen, so geht man folgendermaßen vor:
Der Schichtverbund wird über die Klebeschicht auf den permanenten Schichtträger unter Druck und Erwärmen laminiert und die lichtempfindliche Schicht nach dem Entfernen des temporären Schichtträgers und Abwischen der Trennschicht unter Verwendung des negativen Farbauszuges bildmäßig belichtet. Die Stelle, an welcher das positive Farbprüfbild entstehen soll, wird während des Belichtungsvorganges lichtundurchlässig abgedeckt. Danach wird das belichtete Negativ-Prüfbild 0,5 bis 10 Min bei einer

Temperatur von 70 bis 150 °C, vorzugsweise 80 bis 110 °C getempert und anschließend ganzflächig ausbelichtet. Dabei kann gleichzeitig die Stelle, an der das positive Farbprüfbild entstehen soll, durch den positiven Farbauszug bildmäßig belichtet werden. Hinterher wird die gesamte bildtragende Schicht durch Auswaschen entwickelt. Die so ausgewaschenen Bildanteile sind identisch mit den bei der bildmäßigen Belichtung unbelichteten Stellen (Negativ-Prüfbild) bzw. mit den bei der bildmäßigen Belichtung belichteten Stellen (Positiv-Prüfbild). Zur Erstellung der kompletten Farbprüfbilder wird der Vorgang nacheinander mit den anderen Grundfarben wiederholt.

Dementsprechend verfährt man erfindungsgemäß bei dem Verfahren zur Herstellung eines positiven und eines negativen Farbprüfbildes auf demselben permanenten Schichtträger unter Verwendung des lichtempfindlichen Aufzeichnungsmaterials so, daß man ein Aufzeichnungsmaterial in der ersten Grundfarbe klebeschichtseitig auf einen permanenten Schichtträger mit Hilfe von Druck und Wärme auflaminiert, den temporären Schichtträger abzieht, die Trennschicht abwischt, den Teil des Aufzeichnungsmaterials, der das negative Bild tragen soll unter dem negativen Farbauszug der entsprechenden Grundfarbe belichtet, während der Teil des Aufzeichnungsmaterials, der das positive Prüfbild tragen soll, lichtundurchlässig abgedeckt ist, das belichtete Negativ-Prüfbild 0,5 bis 10 Min bei 70 bis 150 °C tempert, danach nochmals belichtet, wobei nun der Teil für das positive Prüfbild unter dem positiven Farbauszug belichtet wird, während der Teil, der das negative Prüfbild trägt, nicht abgedeckt ist, daß man die so behandelte Schicht durch Auswaschen der belichteteten bzw. nachbelichteten Bereiche entwickelt und über den erhaltenen Teilbildern in entsprechender Weise Teilbilder der weiteren Grundfarben und von Schwarz erzeugt.

Als permanenter Schichtträger können Kunststoff-Folien, z.B. Polyesterfolien oder kunststoffbeschichtete Papiere verwendet werden. Die Oberfläche des permanenten Schichtträgers ist vorzugsweise haftvermittelnd behandelt worden. Der permanente Schichtträger muß unempfindlich gegen die Laminier- und Entwicklungsvorgänge sein.

Durch die Erfindung wird erreicht, daß man nunmehr ein positiv arbeitendes, gefärbtes, lichtempfindliches Aufzeichnungsmaterial zur Herstellung sowohl von positiven als auch negativen Farbprüfbildern zur Verfügung stellen kann, welches eine naturgetreue Farbwiedergabe gewährleistet, in einem einfachen Verfahren leicht handhabbar ist, einen breiten Verarbeitungsspielraum und eine gute Entwicklerresistenz der unbelichteten (Positivverarbeitung) bzw. unlöslich gemachten (Negativverarbeitung) Bereiche besitzt.

Die Erfindung wird anhand der Beispiele näher erläutert, ohne sie hierauf zu beschränken. Sofern nicht anders angegeben, beziehen sich alle Teil- und Prozentangaben auf das Gewicht (Gewichtsteile = GT).

Das folgende Beispiel bezieht sich auf die Herstellung einer cyan-eingefärbten Farbprüffolie.

Beispiel 1

Auf eine 50 µm dicke Folie aus Polyethylenterephthalat als temporärer Schichtträger wird eine Trennschicht aufgebracht, die ein Trockengewicht von 0,7 bis 1,0 g/m$^2$ hat. Die Lösung wird aufgerakelt und bei 110 °C im Trockenschrank für 3 Min getrocknet.

| **Beschichtungslösung I** | |
|---|---|
| Polyvinylalkohol (Pw = 530, Hydrolysegrad 88 Mol.-%) | 1,7 GT |
| Polyvinylalkohol (Pw = 1000, Hydrolysegrad 88 Mol.-%) | 1,7 GT |
| Nonylphenolpolyglykolether | 0,1 GT |
| deionisiertes Wasser | 96,5 GT |

Im folgenden Schritt wird auf die Trennschicht die gefärbte, lichtempfindliche Schicht mit Hilfe einer Schleuder aufgebracht. Die Beschichtungslösung für die lichtempfindliche Schicht stellt man in zwei Stufen her. Zuerst wird die Pigmentdispersion hergestellt.

| Beschichtungslösung IIa | |
|---|---|
| Polyvinylpropionalharz mit 13,6 % Vinylacetat-, 9,8 % Vinylalkohol- und 76,6 % Vinylpropionalgruppen | 5,5 GT |
| Hostapermblau B2G Blaupigment, Color Index (C.I.) 74160 | 6,5 GT |
| Propylenglykolmonomethylether | 44,0 GT |
| $\gamma$ - Butyrolacton | 44,0 GT |

| Beschichtungslösung IIb | |
|---|---|
| Veresterungsprodukt aus 1 Mol 2,3,4-Trihydroxybenzophenon und 3 Mol 1,2-Naphthochinon-(2)-diazid-4-sulfonsäurechlorid | 1,5 GT |
| Polymerisat aus Brenzkatechinmonomethacrylat | 1,9 GT |
| Polymerisat aus Brenzkatechinmonomethacrylat modifiziert mit 10 Gew.-% Phenylisocyanat | 4,4 GT |
| Halogenparaffin (Hordaflex $^R$ LC/60, HOECHST AG) | 0,5 GT |
| Beschichtungslösung IIa | 8,3 GT |
| Propylenglykolmonomethylether | 79,0 GT |
| Tetrahydrofuran | 96,0 GT |

Die Lösung IIb wird auf die mit einer Trennschicht versehene Folie so aufgeschleudert, daß sich nach dem Trocknen (2 Min, 110 °C) ein Schichtgewicht von 1,5 $g/m^2$ einstellt. Die Farbdichte, gemessen mit einem Gretag Densitometer durch einen Blau-Filter, beträgt 1,2.

Auf die gefärbte lichtempfindliche Schicht wird abschließend noch eine Klebeschicht bestehend aus 97 Gewichtsprozent eines Styrol-Butadien-Copolymerisates(Tg = 50 °C) und 3 Gewichtsprozent eines alkalilöslichen Polyesters (Desmophen $^R$ 1700, BAYER AG) mit einem Trockengewicht von 3 $g/m^2$ aufgebracht. Die so erhaltene Farbprüffolie wird mit der Klebeschicht auf ein Empfangsblatt als permanentem Schichtträger laminiert. Geeignete Laminiertemperaturen liegen im Bereich von 110 bis 140 °C. Nach dem Laminieren wird die Polyethylenterephthalat-Folie als temporärer Schichtträger abgezogen. Die Klebeschicht, die gefärbte, lichtempfindliche Schicht und die Trennschicht bleiben dabei auf dem permanenten Schichtträger zurück.

Anschließend wird durch einen positiven Farbauszug bildmäßig mit einer UV-Lampe im Vakuumkopierrahmen belichtet. Nach dem Belichten wird mit einer wäßrigalkalischen Lösung entwickelt, wobei die Trennschicht und die belichteten Stellen der gefärbten lichtempfindlichen Schicht entfernt werden. Man erhält eine getreue Wiedergabe des positiven Originalfarbauszuges.

| Entwicklerlösung: | |
|---|---|
| $K_2SiO_3$ | 3,5 GT |
| $K_3PO_4$ x $H_2O$ | 0,5 GT |
| Natriumoctylsulfat | 3,0 GT |
| Phenoxyethanol | 1,0 GT |
| Deionisiertes Wasser | 92,0 GT |

Um ein vollständiges Farbbild herzustellen werden in gleicher Weise nacheinander je eine magenta-, gelb-, und schwarz-eingefärbte Folie eingesetzt. Dadurch ergibt sich eine genaue Wiedergabe des Originals.

Beispiel 2:

Gefärbtes lichtempfindliches Aufzeichnungsmaterial analog Beispiel 1, bei dem das Polymerisat aus Brenzkatechinmonomethacrylat in der Beschichtungslösung IIb durch einen Novolak (Alnovol$^R$ PN 429, HOECHST AG) ersetzt wird.
Auch hier ergibt sich eine genaue, farbgetreue Wiedergabe des Originals.

Beipiel 3 und 4:

Von der analog zu Beispiel 1 oder 2 hergestellten und auflaminierten Farbprüffolie wird nach Entfernen des temporären Schichtträgers die Trennschicht mit Wasser abgewaschen. Dann wird durch einen negativen Farbauszug bildmäßig belichtet und danach 5 Min lang auf 130 °C erwärmt. Im Anschluß daran wird vollflächig ausbelichtet und danach werden mit der Entwicklerlösung die bei der bildmäßigen Belichtung nicht belichteten Stellen der lichtempfindlichen Schicht, die bei der vollflächigen Ausbelichtung belichtet wurden, entfernt. Man erhält eine getreue Wiedergabe des negativen Originalfarbauszuges. Um ein vollständiges Farbbild herzustellen, werden wieder in gleicher Weise nacheinander je eine magenta-, gelb- und schwarz-eingefärbte Folie eingesetzt. Dadurch ergibt sich eine genaue Wiedergabe des Originals.

Beispiel 5 und 6:

Zum Vergleich werden bei der Beschichtungslösung IIb aus Beispiel 1 oder 2, statt des Halogenparaffins 0,7 g 2,4-Ethoxy-6-diethylamino-s-triazin zugesetzt. Danach wird eine Farbprüffolie nach dem in Beispiel 3 und 4 beschriebenen Verfahren angefertigt. Das Aminderivat bewirkt, daß die zur Bildumkehr benötigte Temperatur auf 110 °C zurückgenommen werden kann.

Beispiele 7 bis 10:

Die in den Beispielen 1, 2, 5 und 6 angeführten Aufzeichnungsmaterialien werden, mit Ausnahme der Klebeschicht, wie beschrieben hergestellt und verarbeitet. Es wird aber eine Klebeschicht eingesetzt, die aus 95 Gewichtsprozent Polyvinylacetat (Mowilith $^{R}$ 50, HOECHST AG) und 5 Gewichtsprozent eines niedrigviskosen Polyesterharzes (Resoflex $^{R}$ R296, CAMBRIDGE INDUSTRIES COMPANY INC.) besteht und mit einem Trockengewicht von 3 $g/m^2$ aufgebracht wird.

Die Aufzeichnungsmaterialien erweisen sich als gut laminierbar. Die resultierenden Farbprüfbilder sind von guter Qualität.

**Patentansprüche**

1. Gefärbtes, positiv-arbeitendes, lichtempfindliches Aufzeichnungsmaterial zur Herstellung eines Farbprüfbildes, bestehend aus einem temporären Schichtträger, auf dem sich eine Trennschicht aus einem Polymeren oder Copolymeren von Vinylalkohol, einem Vinylether oder Vinylacetat, eine lichtempfindliche Schicht, die einen Farbstoff oder ein Pigment, ein Bindemittel, das ein Novolak, ein novolakfreies Phenolharz und/oder ein Umsetzungsprodukt des Novolaks oder des Phenolharzes mit einem Monoisocyanat ist, und einen Ester aus einer Verbindung mit einer oder mehreren phenolischen Hydroxylgruppen und einer o-Chinondiazidsulfonsäure enthält, und eine thermisch aktivierbare, ein alkaliunlösliches Polymerisat und einen alkalilöslichen Polyester enthaltende Klebeschicht befindet, dadurch gekennzeichnet, daß es in der lichtempfindlichen Schicht einen Ester einer o-Chinondiazid-4-sulfonsäure sowie eine weichmachende Verbindung und/oder eine basische Stickstoff- oder Harnstoffverbindung enthält.

2. Aufzeichnungsmaterial nach Anspruch 1, dadurch gekennzeichnet, daß die o-Chinondiazidverbindung ein Veresterungsprodukt des 1,2-Naphthochinon-(2)-diazid-4-sulfonsäurechloridsmit 2,3,4-Trihydroxybenzophenon, 2,4,6-Trihydroxybenzophenon, Bisphenol-A oder 4-tert-Butylphenol ist.

3. Aufzeichnungsmaterial nach Anspruch 1, dadurch gekennzeichnet, daß die weichmachende Verbindung ein Polyester, ein alkali-löslicher Polyester, ein Halogenparaffin oder eine basische Stickstoffverbindung ist.

4. Aufzeichnungsmaterial nach Anspruch 1 oder 3, dadurch gekennzeichnet, daß die basische Stickstoffverbindung ein sekundäres oder teriäres Amin oder ein Melaminderivat ist.

5. Aufzeichnungsmaterial nach Anspruch 4, dadurch gekennzeichnet, daß die basische Stickstoffverbindung ein Triazin darstellt.

6. Aufzeichnungsmaterial nach Anspruch 1, dadurch gekennzeichnet, daß in der lichtempfindlichen Schicht als Bindemittel ein Novolak-Kondensationsharz vorhanden ist.

7. Aufzeichnungsmaterial nach Anspruch 1, dadurch gekennzeichnet, daß in der Klebeschicht ein Vinylacetatpolymerisat oder -copolymerisat oder ein Acrylatpolymerisat oder -copolymerisat, gegebenenfalls in Verbindung mit einem Weichmacher vorhanden ist.

8. Verfahren zur Herstellung eines positiven Farbprüfbildes unter Verwendung des lichtempfindlichen Aufzeichnungsmaterials nach Anspruch 1, bei dem man ein Aufzeichnungsmaterial in der ersten Grundfarbe klebeschichtseitig auf einen permanenten Schichtträger mit Hilfe von Druck und Wärme auflaminiert, den temporären Schichtträger abzieht, das Aufzeichnungsmaterial unter dem positiven Farbauszug der entsprechenden Grundfarbe belichtet, die belichtete Schicht durch Auswaschen der belichteten Bereiche entwickelt und über dem erhaltenen Teilbild in entsprechender Weise Teilbilder der weiteren Grundfarben und von Schwarz erzeugt.

9. Verfahren zur Herstellung eines negativen Farbprüfbildes unter Verwendung des lichtempfindlichen Aufzeichnungsmaterials nach Anspruch 1, bei dem man ein Aufzeichnungsmaterial in der ersten Grundfarbe klebeschichtseitig auf einen permantenten Schichtträger mit Hilfe von Druck und Wärme auflaminiert, den temporären Schichtträger abzieht, gegebenenfalls die Trennschicht feucht abwischt, das Aufzeichnungsmaterial unter einem negativen Farbauszug der entsprechenden Grundfarbe belichtet, das belichtete Prüfbild 0,5 bis 10 Min bei 70 bis 150 °C tempert, danach ganzflächig ausbelichtet, die so nachbelichtete Schicht durch Auswaschen der belichteten Bereiche entwickelt und über dem erhaltenen Teilbild in entsprechender Weise Teilbilder der weiteren Grundfarben und von Schwarz erzeugt.

10. Verfahren zur Herstellung eines positiven und eines negativen Farbprüfbildes auf demselben permanten Schichtträger unter Verwendung des gefärbten lichtempfindlichen Aufzeichnungsmaterials nach Anspruch 1, bei dem man ein Aufzeichnungsmaterial in der ersten Grundfarbe klebeschichtseitig auf einen permanenten Schichtträger mit Hilfe von Druck und Wärme auflaminiert, den temporären Schichtträger abzieht, die Trennschicht abwischt, den Teil des Aufzeichnungsmaterials, der das negative Bild tragen soll, unter dem negativen Farbauszug der entsprechenden Grundfarbe belichtet, während man den Teil des Aufzeichnungsmaterials, der das positive Prüfbild tragen soll, lichtundurchlässig abdeckt, das belichtete Negativ-Prüfbild 0,5 bis 10 Min bei 70 bis 150 °C tempert, danach nochmals belichtet, wobei nun der Teil für das positive Prüfbild unter dem positiven Farbauszug belichtet wird, während der Teil, der das negative Prüfbild trägt, nicht abgedeckt ist, bei dem man weiterhin die so behandelte Schicht durch Auswaschen der belichteten bzw. nachbelichteten Bereiche entwickelt und über den erhaltenen Teilbildern in entsprechender Weise Teilbilder der weiteren Grundfarben und von Schwarz erzeugt.

11. Verfahren nach Anspruch 9 oder 10, dadurch gekennzeichnet, daß man das Aufzeichnungsmaterial nach der bildmäßigen Belichtung mit dem negativen Farbauszug auf eine Temperatur im Bereich von 80 bis 110 °C erwärmt.

12. Verfahren nach Anspruch 9 oder 10, dadurch gekennzeichnet, daß man das Aufzeichnungsmaterial 2 bis 6 Min lang erwärmt.

13. Verfahren nach Anspruch 9 oder 10, dadurch gekennzeichnet, daß man vor dem bildmäßigen Belichten mit dem negativen Farbauszug die Trennschicht abwischt.

14. Verfahren nach Anspruch 13, dadurch gekennzeichnet, daß man die Trennschicht mit Wasser abwischt.

Europäisches Patentamt

# EUROPÄISCHER RECHERCHENBERICHT

Nummer der Anmeldung

EP 92 10 3492

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X,D | EP-A-0 285 014 (HOECHST A.G.)<br>* Spalte 1, Zeile 38 - Spalte 2, Zeile 15 *<br>* Spalte 2, Zeile 31 - Zeile 40 *<br>* Spalte 3, Zeile 6 - Zeile 52 *<br>* Spalte 4, Zeile 6 - Zeile 18 *<br>* Spalte 7, Zeile 27 - Zeile 47 *<br>* Spalte 8, Zeile 49 - Spalte 9, Zeile 8 *<br>--- | 1-14 | G03F3/10 |
| X<br><br>X | EP-A-0 357 325 (HOECHST CELANESE CORPORATION)<br>* Seite 5, Zeile 53 - Zeile 57; Ansprüche 7,12 *<br>* Seite 6, Zeile 33 - Seite 7, Zeile 10; Ansprüche 14,17 *<br>--- | 1<br><br>7 | |
| X | US-A-4 686 171 (C.C. FIIFIELD et Al.)<br>* Spalte 1, Zeile 19 - Zeile 35 *<br>--- | 1,4 | |
| X | GB-A-1 492 620 (FUJI PHOTO FILM CO. LTD.)<br>* das ganze Dokument *<br>--- | 4 | |
| X | JAPANESE PATENTS REPORTS<br>Section Ch, volume 81, no 15, 8. Mai 1981<br>Derwent Publications Ltd., London, GB;<br>Class G, Page 3,<br>& JP-B-81 014 971 (FUJI) 7. April 1981<br>* Zusammenfassung *<br>--- | 1,4 | RECHERCHIERTE SACHGEBIETE (Int. Cl.5)<br>G03F |
| X | US-A-4 157 918 (STANLEY F.WANAT et Al.)<br>* Anspruch 1 *<br>* Spalte 5, Zeile 56 - Spalte 6, Zeile 45 *<br>--- | 1,3 | |
| P,X<br>O | EP-A-0 447 829 (HOECHST A.G.)<br>* das ganze Dokument *<br>----- | 1-14 | |

Der vorliegende Recherchenbericht wurde für alle Patentansprüche erstellt

| Recherchenort | Abschlußdatum der Recherche | Prüfer |
|---|---|---|
| DEN HAAG | 18 JUNI 1992 | RASSCHAERT A. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)